# EUROPEAN PATENT APPLICATION

(11) **EP 0 725 162 A2**
(43) Date of publication of application: **07.08.1996**
(21) Application number: 96300596.2
(22) Date of filing: 29.01.1996
(51) Int. Cl.: C23C 14/04, C23C 14/50, G11B 7/26, G11B 11/10, G11B 23/00

(54) **A pallet for holding an information recording medium, a process for producing an information recording medium employing the same, and an apparatus for the process**

(30) Priority: 31.01.1995 JP 13862/95; 08.12.1995 JP 320294/95
(71) Applicant: CANON KABUSHIKI KAISHA, Tokyo (JP)
(72) Inventor: Hirose, Kenji, Ohta-ku, Tokyo (JP); Koganei, Akio, Ohta-ku, Tokyo (JP); Takada, Kunio, Ohta-ku, Tokyo (JP); Hongu, Kazuoki, Ohta-ku, Tokyo (JP)
(74) Representative: Beresford, Keith Denis Lewis

(57) **Abstract**

A pallet for holding a substrate for information recording medium is provided which is used with an apparatus for producing an information-recording medium having a continuous conveying means for the pallet, and exhibits improvements in handleableness of the substrate and in the production efficiency of the information recording medium. A method of producing an information recording medium employing the pallet, and an apparatus for producing the recording medium are also provided. The pallet comprises a substrate-holding portion which serves to hold the substrate detachably; a mask portion for masking an outer peripheral part of the substrate to prevent formation of an information recording film on the peripheral part of the substrate; and a connecting portion for connecting the pallet with the pallet-conveying means of the apparatus; and the substrate-holding portion, the mask portion, and the connecting portion being integrated into one body.

## Description

The present invention relates to a pallet for holding a substrate for an information-recording medium which is used with an apparatus for producing an information-recording medium having a conveying means for the pallet, a process for producing an information recording medium using the pallet, and an apparatus for producing an information recording medium employing the pallet.

In recent years, a recording media is demanded which has a larger recording capacity and is capable of recording and reproducing information at a higher speed, and is useful for computer memories and image information memories. Various optical disks for recording and/or reproducing with a laser beam are being developed therefor. Among them, particularly promising are photomagnetic recording mediums and phase-change type recording mediums.

The photomagnetic recording medium records and reproduces information by utilizing a Kerr effect that the rotation direction of a plane of projected polarized light on a surface of a magnetized material depends on the direction of the magnetization thereof. A substance which exhibits a larger Kerr rotation angle gives a higher C/N ratio. However, a higher Kerr effect cannot be obtained by simple magnetic recording layer. Generally, a transparent dielectric layer is provided between a magnetic recording layer and a substrate to increase the Kerr rotation angle by optical interference effect (enhancing effect).

On the other hand, the phase-change type recording medium records information by projecting a laser beam onto a thin recording film to heat it and quenching the recording film to bring it into a noncrystalline state, and erases the recorded information by projecting a laser beam onto the recording film to heat it and cooling it gradually. In this phase-change type recording medium also, a dielectric layer is provided between a recording film and a substrate to obtain an optical enhancing effect.

The dielectric layer serves as a protecting film to protect the magnetic layer in addition to the enhancing effect resulting in the optical interference. The dielectric layers are provided generally to hold the magnetic layer therebetween. Further, to obtain a higher optical interference effect, a metallic reflection film is provided in some cases.

The recording medium is a laminate constituted generally of a substrate, a first protecting layer, a recording layer, and a second protecting layer; or constituted of a substrate, a first protecting layer, a recording layer, a second protecting layer, and a reflection layer.

The media for a computer memory and an image memory is required to have a long-term storability of the record. To satisfy the requirement, improvements in performance and durability of the protecting layer are investigated actively throughout the world. It is also generally known that no formation of the recording layer is preferred on the non-effective areas at the outer and inner peripheral portions of the disk: in other words, the constitution is preferred which has the recording layer not exposed to the outside. The reason is that an impurity gas tends to penetrate into the gap between the film and the substrate from the reverse side at the outer or inner peripheral portions of the substrate owing to lower quality of the film formed at the edges, thereby causing deterioration of the recording medium by humidity or the like to cause cracking or swelling of the film with lapse of time. Therefore, a recording medium having the aforementioned constitution is usually produced by forming the recording layer with masks covering the outer and inner peripheral portions of the substrate. The mask is produced usually by machining of aluminum or stainless steel. Otherwise, the mask can be prepared from a film or a plastic material as disclosed in Japanese Patent Laid-Open Application Nos. 5-217229 and 5-303782.

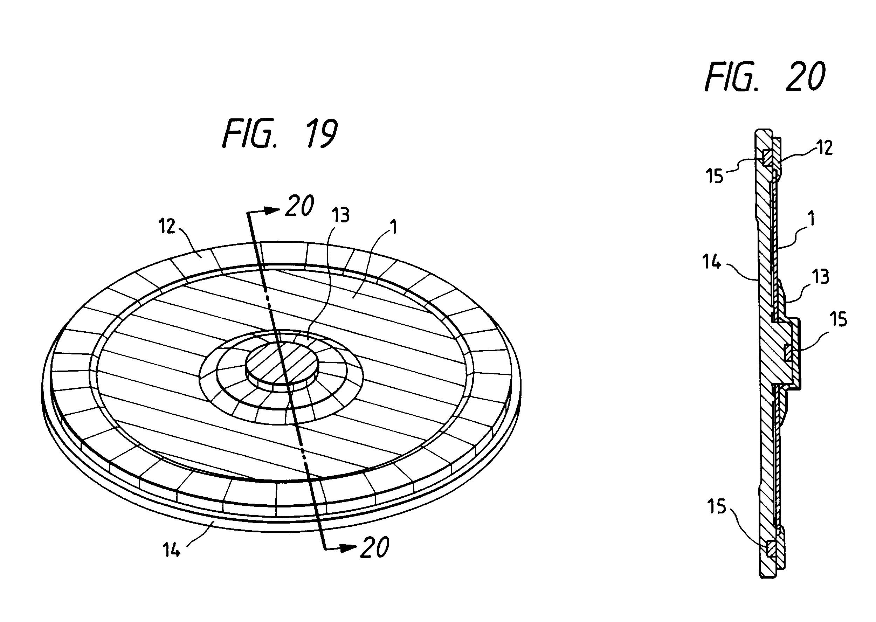

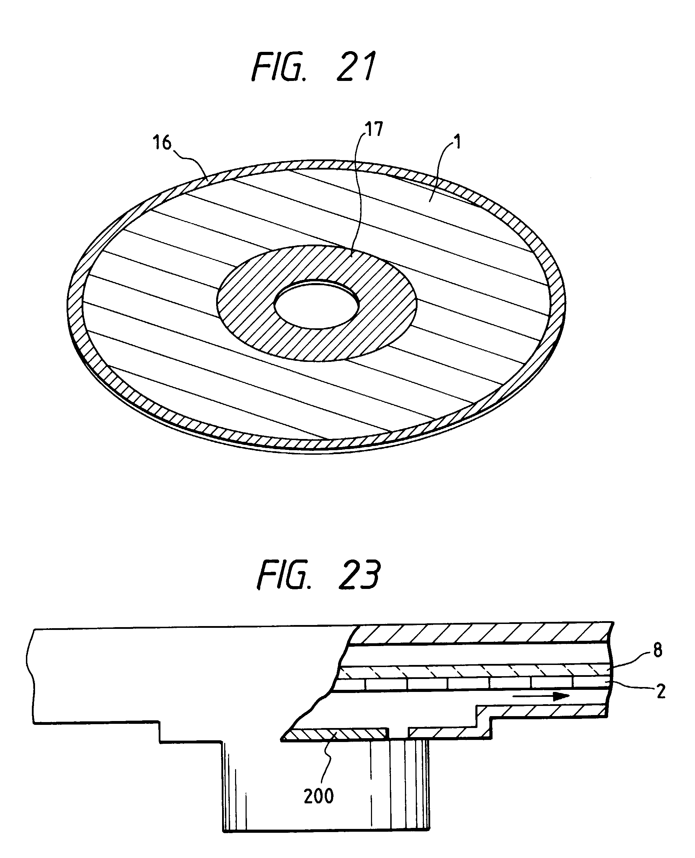

Figs. 19 to 21 show conventional masks. Fig. 19 is a perspective view of a disk substrate having a conventional mask fitted thereon. Fig. 20 is a cross-sectional view of the disk substrate shown in Fig. 19. Figs. 19 and 20 show a substrate 1 for an optical recording medium, an outer peripheral mask 12, and inner peripheral mask 13. The masks 12, 13 are made of a magnetic metal, and are fixed by a magnetic force of a magnet 15 provided on a pallet 14 to hold the substrate 1 between the masks and the pallet. Fig. 21 shows an outer peripheral film mask 16 and an inner peripheral film mask 17 stuck to a substrate 1.

In formation of a film on a substrate, a substrate is prepared, a mask is placed thereon, and the substrate is conveyed to a film formation process. For the conveyance, the substrate having the mask is conveyed, sheet by sheet (single substrate process), to the film formation process by use of a robot arm or the like, or a plurality of the substrates stored in a container in one lot are conveyed to an accumulation dump and are delivered therefrom, sheet by sheet, to the film formation process.

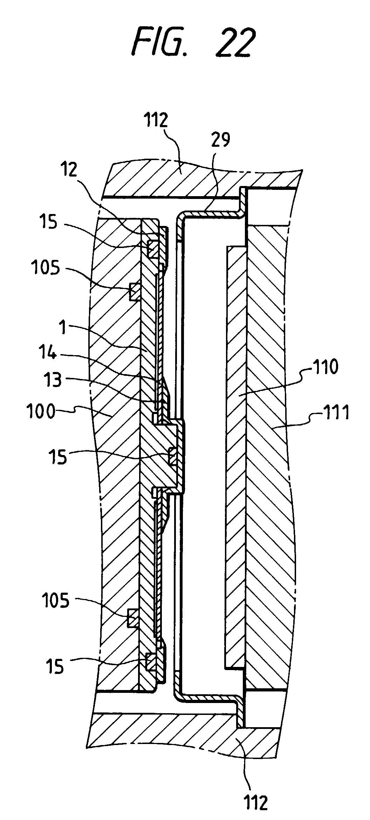

Fig. 22 is a schematic sectional view of an example of a conventional film formation apparatus which conducts film formation on a substrate, by a single substrate process. In this apparatus, a substrate 1, a mask 12, and a pallet 14 are held on an arm 100 by a magnetic force of a magnet 105 fixed to the arm 100. In a film formation chamber 112, a target 110 held by a target holder 111 is placed in opposition to the film-forming face of the substrate 1. A recording film or the like is formed on the substrate 1 by sputtering. In the apparatus, a prevention plate 29 is provided to prevent formation of undesired film in the chamber 112. The prevention plate 29 should periodically be replaced with a fresh one, or treated for removal of a deposited film since the deposited film on the prevention plate 29 can exfoliate to adhere to the substrate as a foreign matter when the deposited film has grown to a certain thickness.

Conventional pallets for holding an optical information recording medium, and conventional processes and apparatuses for producing an optical information recording medium have disadvantages below:
(1) Conventional masks and pallets, which are usually prepared by machining of a metal such as aluminum and stainless steel, are so heavy that improvement of precision and speed in handling cannot readily be achieved;
(2) The masks and pallets, which are prepared by machining, are costly and cannot readily be formed into a complicated shape. Therefore, the masks and pallets are formed in a simple shape of a circle, which renders the handling mechanism complicated. Otherwise, masks made of a film require handling the substrate itself, which requires a complicated handling mechanism. Moreover, the plastic masks are conventionally made in a simple circular ring shape, and the handling mechanism is complicated;
(3) The metallic masks and the metallic pallets are required to be used in a large number in the production process, which results in high production cost. Moreover, the masks have to be honed or washed to prevent defects of the substrate caused by adhesion of the film coming off from the mask onto the substrate. The honing or the washing also results in high production cost;
(4) The metallic masks and pallets are constituted of plural parts for attachment and detachment of the substrate. The plural parts are costly and require a longer time for attachment and detachment thereof; and
(5) The production line employing the single substrate process has to be stopped periodically for maintenance of the prevention plate, which lowers the productivity.

An object of the present invention is to provide a substrate-holding pallet for a production apparatus for information recording medium, the apparatus having a means for conveying continuously a pallet for holding a substrate for an information recording medium, and is improved in handleableness of the substrate and in production efficiency of the recording medium.

Another object of the present invention is to provide a process for production of a recording medium, which is improved in production efficiency of information recording mediums.

A further object of the present invention is to provide an apparatus for production of an information recording medium which produces an information recording medium at a lower cost.

According to an aspect of the present invention, there is provided a pallet for holding a substrate for an information-recording medium used with an apparatus for producing an information recording medium having a pallet-conveying means for conveying the pallet continuously, the pallet comprising a substrate-holding portion which serves to hold the substrate detachably; a mask portion for masking an outer peripheral part of the substrate to prevent formation of an information recording film on the peripheral part of the substrate; and a connecting portion for connecting the pallet with the pallet-conveying means of the apparatus; and the substrate-holding portion, the mask portion, and the connecting portion being integrated into one body.

According to another aspect of the present invention, there is provided a process for producing an information recording medium having a recording layer formed on a substrate, the process comprising steps of: providing an apparatus for producing an information recording medium provided with a chamber for forming a recording layer, and a means for conveying a pallet holding a substrate to the chamber continuously; providing pallets, each comprising a substrate-holding portion which serves to hold the substrate detachably, a mask portion for masking an outer peripheral part of the substrate to prevent formation of a recording film on the peripheral part, and a connecting portion for connecting the pallet to the pallet-conveying means of the apparatus, and the substrate-holding portion, the mask portion, and the connecting portion being integrated into one body; attaching the substrate to the pallet; connecting the pallet holding the substrate to the conveying means of the apparatus; and conveying the pallets to the chamber continuously to form a recording layer on the substrate.

According to a further aspect of the present invention, there is provided an apparatus for producing an information recording medium having a recording layer on a substrate: the apparatus comprising a chamber for forming the recording layer; a means for conveying a pallet for holding the substrate to the chamber; and a pallet comprising a substrate-holding portion which serves to hold the substrate detachably; a mask portion for masking an outer peripheral part of the substrate to prevent formation of a film of the information recording medium on the peripheral part of the substrate; and a connecting portion for connecting the pallet with the pallet-conveying means of the apparatus; the substrate-holding portion, the mask portion, and the connecting portion being integrated into one body; and the pallet being detachably connected with the pallet-conveying means.

With the above constitution, a mask is fit to the peripheral portion of the substrate simultaneously with the fixation of the substrate onto the pallet, which renders an additional peripheral mask unnecessary, thereby lowering the cost of the parts.

The substrate handleableness is improved by providing a connecting means for engagement with a pallet-conveying means in integration with a pallet having a substrate-holding portion in the apparatus for producing an information-recording medium.

A number of embodiments of the invention will now be described, by way of example only, with reference to the drawings in which:
Fig. 1 is a perspective view of the pallet of Example 1.
Fig. 2 is a sectional view of the substrate-holding portion of the pallet of Fig. 1.
Fig. 3A and Fig. 3B are sectional views of the substrate-holding portion for explaining the attachment and detachment of the substrate to or from the pallet.
Fig. 4 is a perspective view showing the state of fitting of inner peripheral mask to the pallet.
Fig. 5 is a sectional view of the fitting portion of the inner peripheral mask of the pallet of Fig. 1.
Fig. 6 is a plan view showing the state of conveyance of the pallets of Fig. 1.
Fig. 7 illustrates schematically the pallets of Fig. 1 fitted to a recording medium-producing apparatus.
Fig. 8 is a sectional view taken on line 8-8 in Fig. 7.
Fig. 9 is a perspective view of the pallet of Example 2.
Fig. 10 is a plan view showing the state of fitting of the pallet of Fig. 9 to a pallet-conveying means.
Fig. 11 is a perspective view of the pallet of Example 3.
Fig. 12 is a plan view showing the state of fitting of the pallet of Fig. 11 to a pallet-conveying means.
Fig. 13 is a sectional view of the main portion of a connecting portion of the pallet of Fig. 11 for engagement with a pallet-conveying system in an apparatus for producing an information recording medium.
Fig. 14 is a perspective view of the main portion of a connecting portion of the pallet of Fig. 11 with a pallet-conveying system in an apparatus for producing an information recording medium.
Fig. 15 is a sectional view showing a state of the engagement of the main portion of the pallet of Fig. 11 with a pallet-conveying system in an apparatus for producing an information recording medium.
Fig. 16 is a side view showing a modification of the pallet-holding method.
Fig. 17 is a perspective view of the pallet of Example 4.
Fig. 18 illustrates schematically the pallets of Fig. 1 fitted to a recording medium-producing apparatus.
Fig. 19 is a perspective view of a substrate for an information recording medium having a conventional metallic mask fitted thereon.
Fig. 20 is a sectional view taken on line 20-20 in Fig. 19.
Fig. 21 is a perspective view of a substrate for an information recording medium having a conventional film mask fitted thereon.
Fig. 22 is a sectional view showing a state of fitting of a conventional metallic mask onto a film-forming apparatus.
Fig. 23 is a partial sectional view of an apparatus for information recording medium of an embodiment of the present invention.

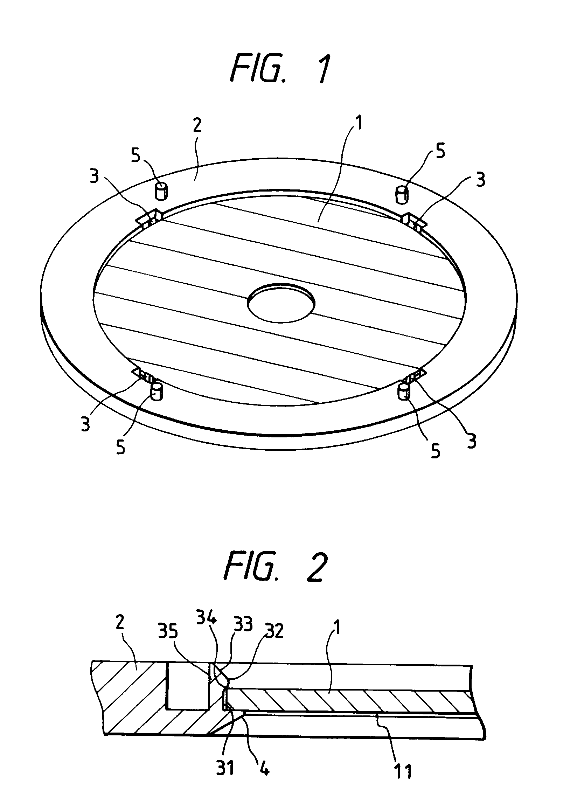

Fig. 1 is a perspective view of a pallet of the first example of an embodiment of the present invention, showing a state of holding a substrate 1 of a recording medium by the pallet 2. The pallet 2 has substrate-holding portions 3. Fig. 2 is a sectional view of the main portion of the pallet of Fig. 1. In Fig. 2, the substrate-holding portion 3 has an undercut 31 and a protrusion 32. The protrusion serves to hold the substrate and to prevent coming-off of the substrate 1 from the pallet. The mask 4 prevents formation of a film on the peripheral portion of the substrate 1 by covering the peripheral portion of the substrate 1. In Fig. 1, pins 5 engage the pallet 2 with a conveying means for conveying the pallet in the production line. As shown in the drawings, the pallet 2 is formed from a resin in integration with the substrate-holding portions 3, the mask portion 4, and the pins 5.

The function of each of the portions is explained successively.

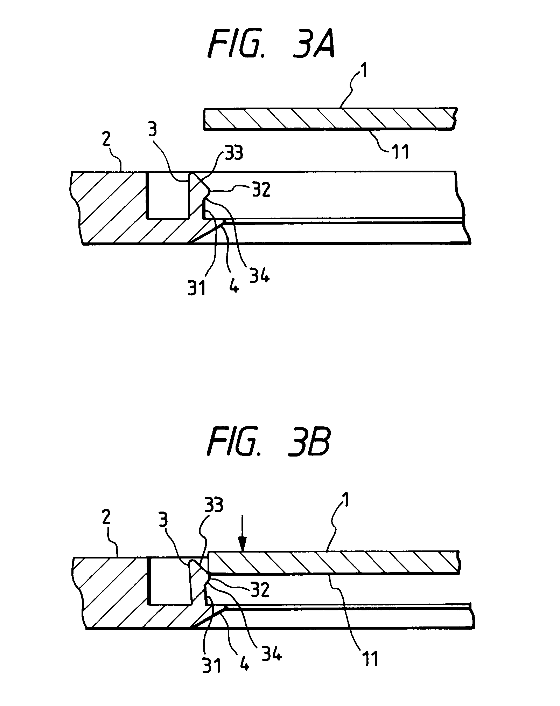

Fig. 3A and Fig. 3B are sectional views of the substrate-holding portion 3 for explaining the attachment and detachment of the substrate 1 to or from the pallet 2. In an initial state as shown in Fig. 3A, a hook 35 of the substrate-holding portion 3 is undeformed. By pressing the substrate 1 downward (in the arrow mark direction) as shown in Fig. 3B, the taper face 33 of the hook 35 is pushed outward in the direction of radius of the substrate, and the protrusion 32 comes to fit to the outside diameter of the substrate 1. By forcing the substrate down further, the substrate 1 is brought to the undercut 31 which is outside the diameter of the substrate 1, and reaches the peripheral mask portion 4, when the hook 35 is released from the external force to return to the original state by its elasticity. Thereby, the substrate 1 is fixed to the pallet by the protrusion 32 not to come off from the pallet 2. In this example, as described above, the substrate-holding portion 3 has a so-called snap-fit structure. In this holding state, deformation of the substrate 1 is avoided by providing a suitable clearance between the substrate 1 and the substrate-holding portion 3 which holds the substrate detachably by elasticity of the hook 35 to preclude unnecessary stress exerting to the substrate 1. To remove the substrate 1 from the pallet 2, the substrate 1 is pulled out upward. Thereby, the hook 35 is deformed to allow the protrusion 32 to fit to the outside diameter of the substrate 1 by the force applied to the taper face 34 of the hook 35 for removal of the substrate 1. Since the substrate-holding portion 3 is required to be deformable elastically, the pallet 2 is preferably made of a resin material having a suitable elasticity. In the above example, the substrate-holding portion 3 is deformed directly by the substrate in attachment and detachment of the substrate. However, a jig may be employed for the deformation on attaching and detaching the substrate. It is preferred to prepare the pallet from the same material as the disk substrate to avoid the deformation caused by temperature rise by the difference of the expansion coefficients in order to prevent coming-off of the substrate from the substrate-holding portion or application of an undesired external force by the substrate-holding portion to the substrate.

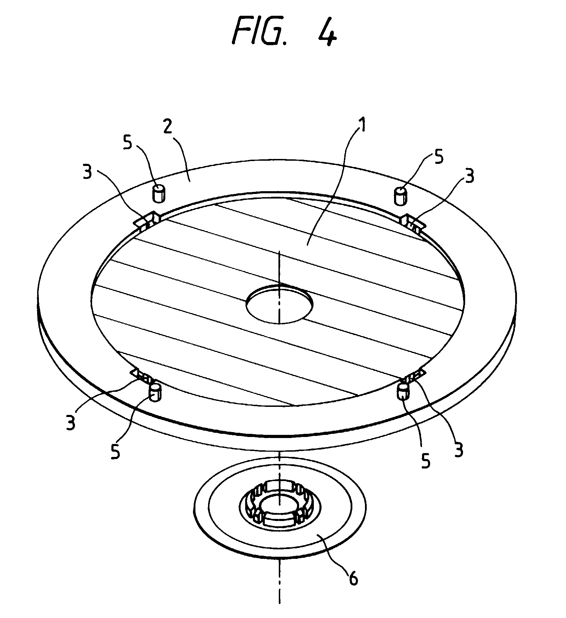

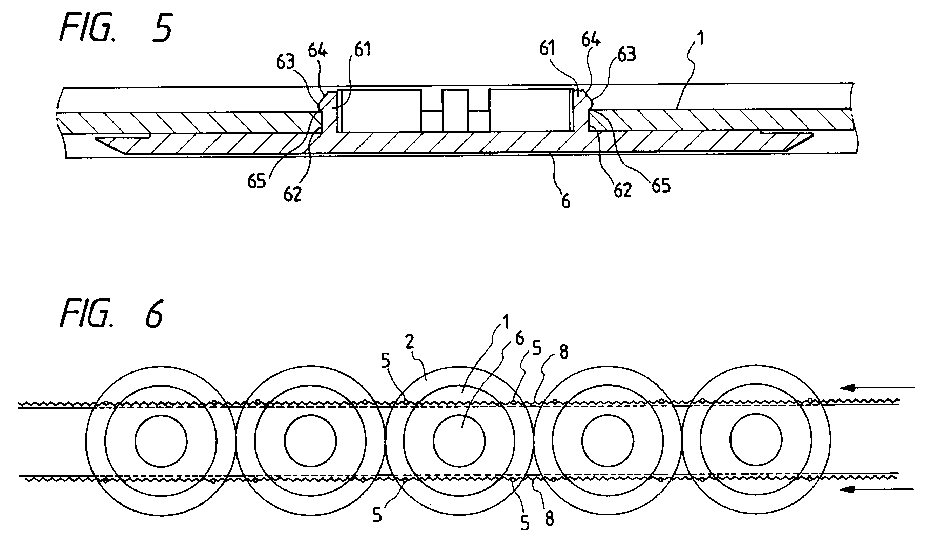

After the substrate 1 is fixed to the pallet 2, an inner peripheral mask 6 is fit to the center hole of the substrate 1 as shown in Fig. 4. Then the substrate is conveyed to a film formation process. Fig. 5 is a sectional view showing the state of the inner peripheral mask 6 fixed onto the substrate 1. In this example, the inner peripheral mask 6 is also formed from a resin material integrally. A holding portion 61 holds the substrate 1. The holding portion 61 has a kind of snap-fit structure to hold the substrate 1 at the center hole, having a taper faces 64, 65, protrusion 63, an undercut 62 similarly as the substrate-holding portion 3 of the pallet 2. The pallet 2 and the inner peripheral mask can be built in by simple pushing onto the same face of the substrate, so that one-step assemblage is practicable.

After the substrate 1 and the inner peripheral mask 6 are fixed to the pallet 2, the pallet 2 is conveyed to the film forming process. For the conveyance, the pins 5 are engaged with dents of the belt 8 as shown in Fig. 6 in this example, and the belt 8 is moved to convey the pallet to a film-forming chamber such as the one shown in Fig. 23 having a sputtering target 200. There, a recording film is formed.

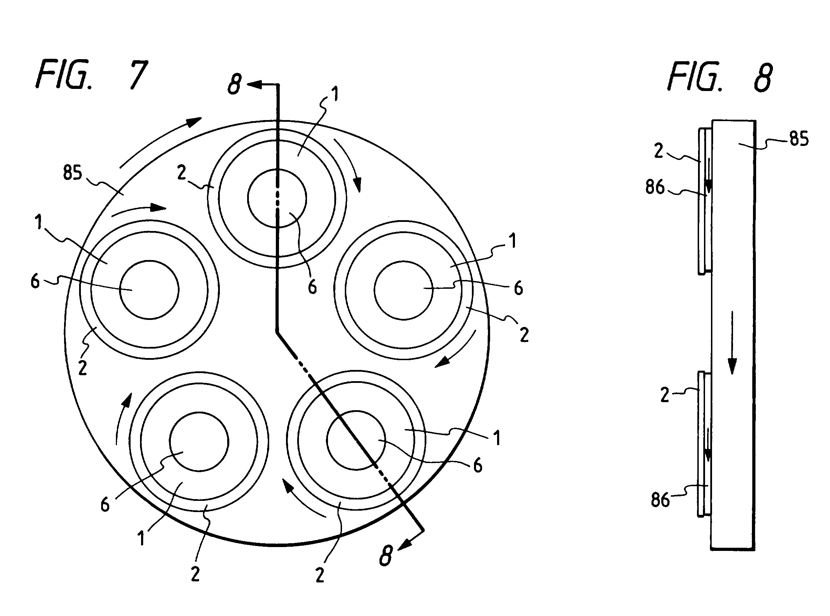

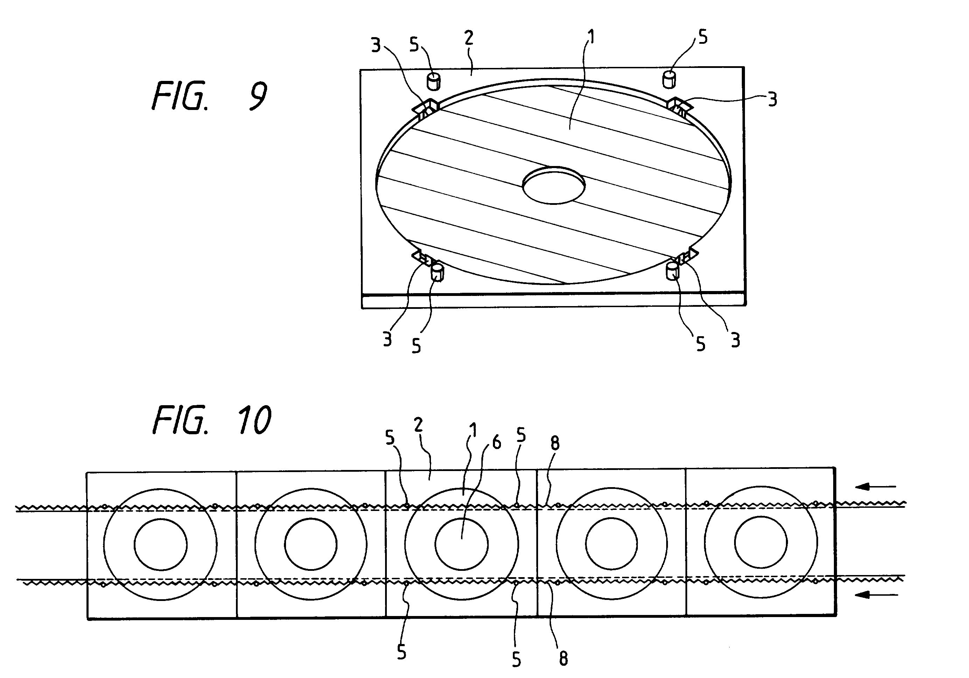

Fig. 7 shows an example of substrate-setting portion of a rotation-revolution type film-forming apparatus using the pallets of this example. Fig. 8 is a sectional view taken on line 8-8 in Fig. 7. In Figs. 7 and 8, the revolution table 85 rotates in the arrow mark direction. On the revolution table 85, plural rotation tables 86 (not shown in Fig. 7) are provided, which rotates with pallets 2 held thereon in the arrow mark direction. Thus films are formed on the film-formation face of the substrate 1. For such a rotation-revolution type film-forming apparatus, pallets are preferably in a shape of a circle to save the space. In a conventional sheet-by-sheet film-forming apparatus also, the use of a circular pallet enables the construction of film-forming apparatus in a smaller circular shape. Therefore, pallets having an external shape of a circle as in this example are suitable for use in a conventional sheet-by-sheet type or rotation-revolution type of film-forming apparatus.

After completion of the process with the pallets, the substrate 1 is removed from the pallet 2. The used pallets are discarded. The repeated use of the conventional metallic mask is costly owing to the high cost for post-treatment of washing and so forth. In the present invention, however, the pallet 2 and the inner peripheral mask 6 can be formed by use of one mold, and setting of the substrate 1 to the pallet 2 immediately after the formation of the pallet 2 renders unnecessary the washing and drying of the pallets 2 and the inner peripheral masks 6. This requires only the cost for the material of the pallet 2 and for the molding thereof. Since the amount of the material of the pallet for one substrate is slight, the cost is much lower than conventional systems. The recycle of the material of the pallet 2 can be practicable by selecting the kind of the material resin to regenerate the pallet 2 or the inner peripheral mask 6, or to reuse the material resin for the parts for an optical disk such as a cartridge or a case.

In this example, the substrate-holding portions 3 and the mask portion 4 of the pallet 2 are formed integrally from a resin in a snap-fit structure. Therefore, the outer peripheral mask 4 and the pallet 2 can be attached to the substrate 1 simultaneously. Moreover, the portions to be held by the conveying system of the information recording medium production apparatus can be formed simultaneously therewith, thereby improving the handleableness, and extending the freedom of design of the conveying system. Further, the pallet 2 can be formed to be light-weight from a resin material, enabling increase of the conveying speed. The parts of the pallet 2 and the outer peripheral mask 4 can be formed in integration to lower the cost of the parts. The pallet may be discarded after one use, whereby the cost is reduced in comparison with the repeated use of the conventional mask even in consideration of the material cost and the molding cost. Thus the present invention achieves great advantage industrially.

### Example 2

Fig. 9 shows a perspective view showing a state of a substrate held by a pallet of the second example of an embodiment of the present invention. The pallet 2 comprises a substrate-holding portions 3, pins 5 for engaging the pallet 2 to a conveying means for conveying the pallet 2, and an outer peripheral mask portion 4 for preventing film-formation on the peripheral portion of the substrate 1, and has basic constitution and function similar to those of Example 1. This example is different from Example 1 in that the shape of the pallet 2 is square. The substrate-holding portion 3 and the inner peripheral mask 6 are the same as those in Example 1 in the constitution. In this example, because of the square shape of the pallet 2, the spaces between the pallets 2 are eliminated on the belt type conveying system, and the pallets 2 cover entirely the conveying belt 8. Therefore, even if substrate-conveying system of an information-recording medium production apparatus is passed through a film-forming chamber to form a film continuously, an undesired film does not deposit onto the conveying belt 8.

Thus, the pallet of this example lengthen the maintenance cycle of the conveying system of the information recording medium production apparatus, and improves the productivity of the information recording medium.

### Example 3

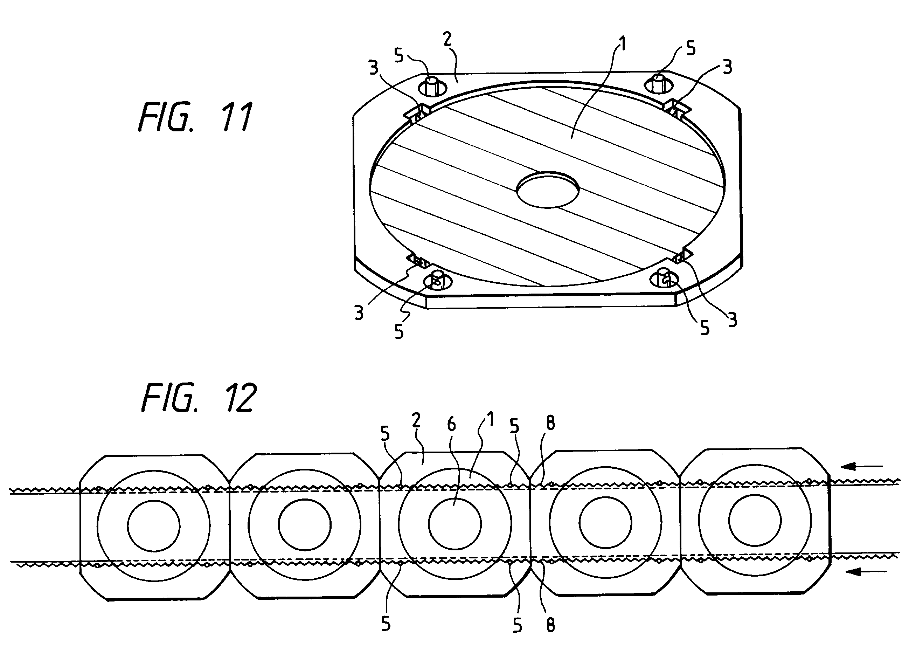

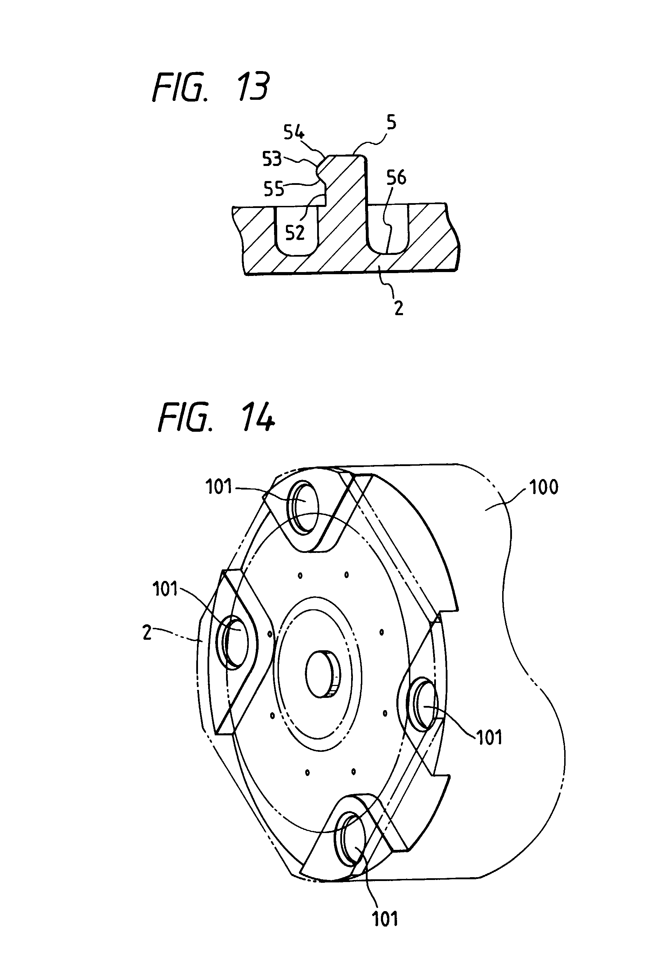

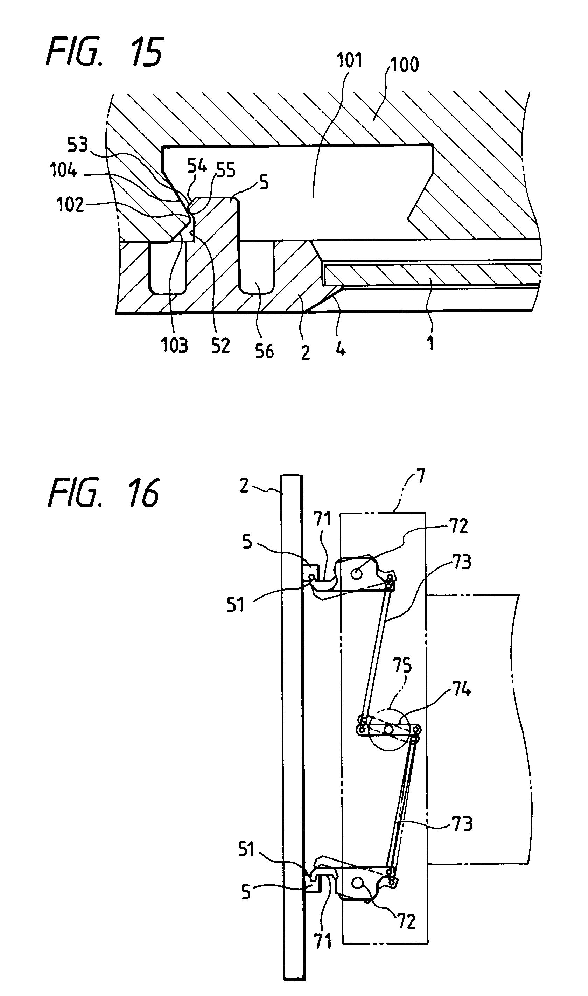

Fig. 11 shows a perspective view showing a state of a substrate held by a pallet of the third example of an embodiment of the present invention. The pallet of this example is the same as that of Example 1 or Example 2 in the basic constitution. The parts of the same function having the same name as in Examples 1 and 2 are represented in this example by the same numerals without explanation. The pallet of this example is different from the ones of Examples 1 and 2 in that the external shape of the pallet 2 is square with its four corners cut in a circular arc. The substrate-holding portions 3 and the inner peripheral mask 6 have the same constitution as in Examples 1 and 2. In this example, because of the arc-cut square shape of the pallet, the pallets 2 can cover the conveying belt 8 of the continuous conveying system by placing the pins 5 in suitable positions as shown in Fig. 12. Further, the pallet 2, which has arc-cut corners, can be fed to a smaller chamber such as a film-forming chamber of a sheet-by-sheet film-forming apparatus. Further, the pin 5 has, at the outside, an undercut 52 and a protrusion 53 as shown by the sectional view of the main portion of the pin 5 in Fig. 13. The pin 5 engages with a hole 101 having a taper 102 provided on an arm 100 of a conveying system of an information recording medium production apparatus as shown in Fig. 14. Fig. 15 is a sectional view of the main portion thereof having a snap-fit structure by which the pin 5 is held detachably by the tapered hole of the arm 100. Therefore, the pallet 2 can be attached to and detached from the arm 100 readily with a simple motion without a complicated mechanism.

Fig. 16 shows a modification of engagement of a pallet 2 with a conveying system, where a swingable finger 71 provided on a hand 7 engages with a notch 51 on the pin 5. As exemplified above, various modifications is possible in engaging the pallet 2.

According to this example as described above, an optimum film-forming system, such as continuous film formation and sheet-by-sheet film formation, and an optimum conveying system can be selected for the respective film constitution in production of optical recording medium having a complicated film constitution. Further the freedom is extended in selection of attaching and detaching of the pallet to or from the apparatus for optimizing the production process.

### Example 4

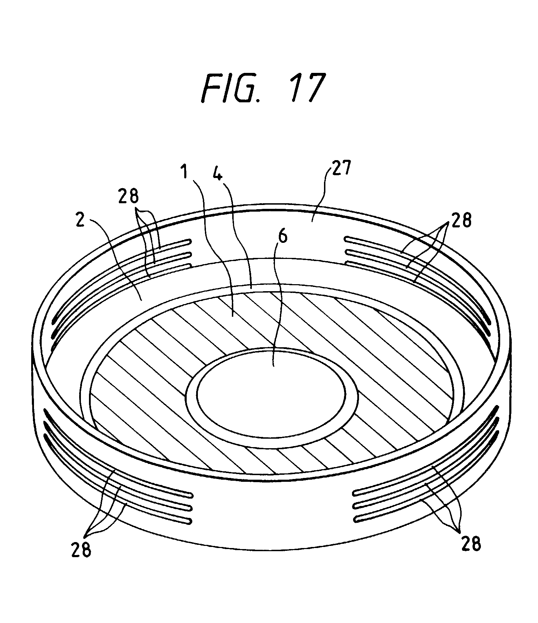

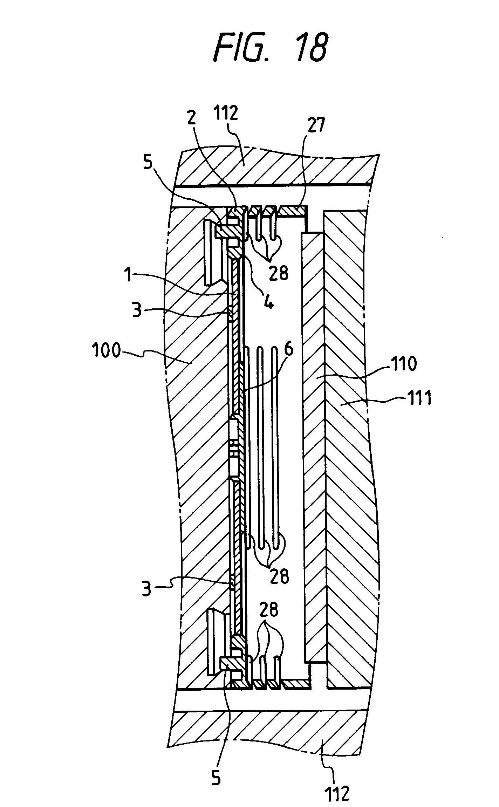

Fig. 17 is a perspective view showing the fourth example of an embodiment of the present invention. Fig. 18 is a sectional view showing a state of the pallet of Fig. 17 held in a film-forming apparatus. The pallet of this example is the same as those of Examples 1 to 3 in the basic constitution and functions. Therefore, the parts of the same function having the same name as in Examples 1 to 3 are represented in this example by the same numerals without explanation. In Figs. 17 and 18, a pallet 2 is formed in integration with a wall 27, and is fixed to an arm 100 of a film-forming apparatus by a snap-fit structure of pins 5 in the same manner as in Example 3. In this example, the film is formed by sputtering. A target 110 is held by a target holder 111 in opposition to the surface of the substrate 1, on which the film is formed. The wall 27 is formed at the side of a mask portion 4 of the pallet 2 to surround the outer periphery of the substrate and to serve as a plate for preventing deposition of undesired film in the film forming process. Slits 28 on the wall 27 are paths for electric charges generated in sputtering at the target 110 to a chamber 112 serving as the anode. The wall 27 formed integrally with the pallet 2 surrounds the target 110, and the slits 28 are formed through the wall in inclination such that the inside opening of the slit is nearer to the substrate 1 and the outside opening thereof is nearer to the target 110, whereby the sputtered atoms are less liable to leak to the outside of the wall 27. Therefore the film deposits little on the film-forming chamber 112.

The pallet 2 of this example has a film-formation prevention mechanism. Therefore, an additional film-formation prevention mechanism need not be provided in the film-forming apparatus. Owing to the absence of the film-formation prevention mechanism and needlessness of maintenance operation therefor, the downtime of the film-forming apparatus is reduced and the production efficiency is improved.

As described above, according to the first embodiment of the present invention, a pallet is provided for conveying an optical information-recording medium having a recording layer on a substrate. The pallet comprises a substrate-holding portion, a connecting portion for connection thereof with a pallet-conveying means, and a peripheral mask portion which are formed integrally. Therefore, the substrate can readily be attached to the pallet, and simultaneously be fit to the mask. Further, the structure of the substrate-conveying system of the recording medium-production apparatus can be simplified, thereby reducing the apparatus cost. The pallet can be made from a resin to make the pallet light-weight, thereby enabling speed-up of pallet conveyance, and improvement of handling precision. Since the resin mask is less expensive than the metal mask, the use of a resin mask is more economical than the repeated use of a conventional metal mask, even when the resin mask is discarded after one use.

In case that the pallet is made of a material which is same as that of the substrate, such as a resin material, even when the peripheral temperature of the pallet holding the substrate is fluctuated, the pallet can prevent the substrate from disengaging from the pallet and it can be avoided that undesired stress is added to the substrate, since the thermal deformation ratio of the pallet is same as that of the substrate.

The snap-fit structure of the substrate-holding portion of the pallet enables one-touch attachment or detachment of the pallet. Thereby the parts are reduced in number, and the pallet can be attached and detached readily and rapidly, thereby the production speed being improved.

Since the pallet has a function of film-formation prevention, an additional film-formation prevention function need not be provided in the film-forming apparatus. Owing to the absence of the film-formation prevention function and needlessness of maintenance operation therefor, the downtime of the film-forming apparatus is reduced and the production efficiency is improved.

According to the second embodiment of the present invention, a method and a process are provided for producing an optical information recording medium having a recording layer on a substrate. The method and the apparatus employ a pallet for conveying the recording medium and a conveying means for conveying the recording medium. The pallet comprises a substrate-holding portion and a connecting portion for engaging the pallet with a pallet-conveying means formed integrally. The conveying means conveys the pallet by utilizing the connecting portions of the pallet, thereby the conveying means being simplified in its structure, thereby reducing the apparatus cost and raising the freedom in design to reduce the apparatus cost. The pallet can be made from a resin to make the pallet light-weight, thereby enabling speed-up of pallet conveyance, and improvement of handling precision. Since the resin mask is less expensive than the metal mask, the use of a resin mask is more economical than the repeated use of a conventional metal mask, even when the resin mask is discarded after one use.

According to the third embodiment of the present invention, a method and a process are provided for producing an optical information recording medium having a recording layer on a substrate, which employ a pallet for conveying a recording medium substrate, a conveying means for conveying the pallet, and a film-forming chamber for forming a film on the substrate having been conveyed therein, the pallet having a wall surrounding the film forming face of the substrate to prevent film deposition onto the wall of the film-forming chamber and to eliminate the necessity of a film-formation prevention mechanism such as a prevention plate in the chamber. The needlessness of the film-formation prevention mechanism reduces the downtime of the film-forming apparatus to improve the production efficiency.

## Claims

1. A pallet for holding a substrate for an information-recording medium used with an apparatus for producing an information recording medium having a pallet-conveying means for conveying the pallet continuously, the pallet comprising:
a substrate-holding portion which serves to hold the substrate detachably;
a mask portion for masking an outer peripheral part of the substrate to prevent formation of an information-recording film of the information recording medium on the peripheral part of the substrate; and
a connecting portion for connecting the pallet with the pallet-conveying means of the apparatus; and
the substrate-holding portion, the mask portion, and the connecting portion being integrated into one body.

2. A pallet according to claim 1, wherein the pallet is made of the same material as the substrate.

3. A pallet according to claim 2, wherein the material is a polymer.

4. A pallet according to claim 1, wherein the substrate-holding portion comprises a hook for holding the substrate by elasticity of the hook.

5. A pallet according to claim 1, wherein the substrate-holding portion comprises a hook for holding detachably the substrate by elasticity of the hook.

6. A pallet according to claim 5, wherein the hook comprises a protrusion for hooking the substrate at the substrate-holding portion not to drop out, and a first inclined face for allowing the hook to bend elastically to dislocate the protrusion on pressing the substrate into the substrate-holding portion.

7. A pallet according to claim 6, wherein the hook further comprises a second inclined face for allowing the hook to bend elastically to dislocate the protrusion on removing the substrate from the substrate-holding portion.

8. A pallet according to claim 6, wherein the connecting portion comprises a pin for connecting the pallet with the pallet-conveying means detachably by elasticity of the hook.

9. A pallet according to claim 8, wherein the pin comprises a protrusion for engaging with the pallet-conveying means, a first inclined face to allow the pin to bend by elasticity to dislocate the protrusion on engaging the pallet with the pallet-conveying means, and a second inclined face to allow the pin to bend by elasticity to dislocate the protrusion on removing the pallet from the pallet-conveying means.

10. A pallet according to claim 1, which further comprises a wall along an outer periphery of the pallet, and the wall extends toward a side reverse to the connecting means.

11. A pallet according to claim 1, wherein the wall has a slit running horizontally across the wall.

12. A pallet according to claim 11, wherein the slit is provided so as to have a sectional shape which includes a through-hole descending from the outside of the wall to the inside of the wall.

13. A process for producing an information recording medium having a recording layer formed on a substrate, the process comprising steps of:
providing an apparatus for producing an information recording medium, provided with a chamber for forming a recording layer, and a means for conveying a pallet holding a substrate to the chamber continuously;
providing pallets according to any one of claim 1 to 12;
attaching the substrate to the pallets;
connecting the pallet holding the substrate to the conveying means of the apparatus; and
conveying the pallets to the chamber continuously to form a recording layer on the substrate.

14. An apparatus for producing an information recording medium having a recording layer on a substrate, the apparatus comprisng:
a chamber for forming the recording layer;
a means for conveying a pallet for holding the substrate to the chamber, and
a pallet according to any one of claim 1 to 12;
and the pallet being detachably connected with the pallet-conveying means.

15. A pallet for holding a substrate for an information-recording medium, the pallet including mask means for preventing deposition of the information recording medium over one or more areas of the substrate.

16. A process for producing an information recording carrier comprising placing the substrate for the carrier on a pallet, and depositing an information-recording medium on the substrate, wherein the pallet prevents deposition of the information recording medium over one or more areas of the substrate.

17. An information recording carrier producing along a pallet according to any one of Claims 1 to 12 or 15 or using a process according to any one of Claims 13 or 16.
